# EUROPEAN PATENT APPLICATION

(11) **EP 3 355 295 A1**
(43) Date of publication of application: **01.08.2018**
(21) Application number: 16822364.2
(22) Date of filing: 18.02.2016
(51) Int. Cl.: G09G 3/20

(54) **GOA UNIT, GATE DRIVING CIRCUIT AND DISPLAY DEVICE**

(30) Priority: 23.09.2015 CN 201510614177
(71) Applicant: BOE Technology Group Co., Ltd., Beijing 100015 (CN)
(72) Inventor: SHANG GUAN, Xingchen, Beijing 100176 (CN)
(74) Representative: Rieder, Hans-Joachim
(86) International application number: PCT/CN2016/073981
(87) International publication number: WO 2017/049853

(57) **Abstract**

A gate on array (GOA) unit, a gate driver circuit, and a display device are provided. The GOA unit includes a driver circuit configured to output a first clock signal from an output end of the GOA unit. The GOA unit further includes a pull-down circuit connected with the driver circuit, the pull-down circuit also connected with at least one low-voltage end that provides a low-voltage signal, the pull-down circuit configured to input the low-voltage signal into a control end of the driver circuit to drive the driver circuit to be in an off state when the GOA unit outputs an off signal. The GOA unit can avoid incorrect switching-on of one row of pixels corresponding to the GOA unit, so that the row of pixels cannot be charged and display incorrect images, and hence an "abnormal image" phenomenon can be overcome.

## Description

### TECHNICAL FIELD

The present disclosure relates to the field of display technology, in particular to a gate on array (GOA) unit, a gate driver circuit and a display device.

### BACKGROUND

In a display device, a gate driver circuit provides on signals, so that a plurality of rows of pixels can be sequentially and progressively switched on, and hence display can be achieved. Generally, the gate driver circuit includes multi-stage shift registers, and each shift register corresponds to one row of pixels. Before switching on a row of pixels, a shift register corresponding to the row of pixels generates a driving signal, which is hence inputted into a gate line connected with the row of pixels, thereby driving the row of pixels to be switched on.

Currently, in order to obtain light and thin display devices, more and more gate driver circuits adopt GOA technology. In the technology, a gate driver chip is disposed on an array substrate. In the gate driver circuit adopting the GOA technology, the shift registers are referred to as GOA units.

In the current display device, each GOA unit outputs an off signal after driving one row of pixels corresponding to the GOA unit to be switched on and is in a flooding state. In this case, due to signal crosstalk, the GOA unit in the flooding state can be easily and incorrectly switched on by a signal which is coupled in, causing one row of pixels that correspond to the GOA unit to be charged and switched on. Hence, incorrect images can be displayed, that is, an "abnormal image" phenomenon can be caused.

### SUMMARY

Embodiments of the present disclosure provide a GOA unit, a gate driver circuit and a display device in order to solve at least the above technical problems in existing technologies, which can avoid the incorrect switching-on of one row of pixels corresponding to the GOA unit, so that the row of pixels cannot be charged and display incorrect images, and hence the "abnormal image" phenomenon can be overcome.

Embodiments of the present disclosure provide a gate on array (GOA) unit, comprising: a driver circuit configured to output a first clock signal from an output end of the GOA unit; and a pull-down circuit connected with the driver circuit, the pull-down circuit also connected with at least one low-voltage end that provides a low-voltage signal, the pull-down circuit configured to input the low-voltage signal into a control end of the driver circuit to drive the driver circuit to be in an off state when the GOA unit outputs an off signal.

The pull-down circuit includes a first sub-circuit, a second sub-circuit and a third sub-circuit. A first end of the first sub-circuit is connected with the control end of the driver circuit; a second end of the first sub-circuit is connected with the at least one low-voltage end; a third end of the first sub-circuit is connected with the second sub-circuit and the third sub-circuit. A first end of the second sub-circuit is connected with a signal input end; a second end of the second sub-circuit is connected with a second clock signal; a third end of the second sub-circuit is connected with the third end of the first sub-circuit. A first end of the third sub-circuit is connected with the at least one low-voltage end; a second end of the third sub-circuit is connected with the control end of the driver circuit; and a third end of the third sub-circuit is connected with the third end of the first sub-circuit.

The pull-down circuit further includes a fourth sub-circuit. A first end of the fourth sub-circuit is connected with the output end of the GOA unit; a second end of the fourth sub-circuit is connected with the at least one low-voltage end; and a third end of the fourth sub-circuit is connected with the third end of the second sub-circuit and the third end of the third sub-circuit.

The second sub-circuit includes a first transistor and a second transistor. A control electrode of the first transistor is the second end of the second sub-circuit and connected with the second clock signal; a source electrode of the first transistor is the first end of the second sub-circuit and connected with the signal input end; a drain electrode of the first transistor is connected with a control electrode and a source electrode of the second transistor. A drain electrode of the second transistor is the third end of the second sub-circuit and connected with the third end of the first sub-circuit. A high voltage signal or the second clock signal is inputted from the signal input end.

The third sub-circuit includes a third transistor. A control electrode of the third transistor is the second end of the third sub-circuit and connected with the control end of the driver circuit; a source electrode of the third transistor is the first end of the third sub-circuit and connected with the at least one low-voltage end; and a drain electrode of the third transistor is the third end of the third sub-circuit and connected with the third end of the first sub-circuit.

The first sub-circuit includes a fourth transistor. A control electrode of the fourth transistor is the third end of the first sub-circuit and connected with the second sub-circuit and the third sub-circuit; a source electrode of the fourth transistor is the second end of the first sub-circuit and connected with the at least one low-voltage end; and a drain electrode of the fourth transistor is the first end of the first sub-circuit and connected with the control end of the driver circuit.

The fourth sub-circuit includes a fifth transistor. A control electrode of the fifth transistor is the third end of the fourth sub-circuit and connected with the third end of the second sub-circuit and the third end of the third sub-circuit; a source electrode of the fifth transistor is the second end of the fourth sub-circuit and connected with the at least one low-voltage end; and a drain electrode of the fifth transistor is the first end of the fourth sub-circuit and connected with the output end of the GOA unit.

The first sub-circuit includes a fourth transistor; the second sub-circuit includes a first transistor and a second transistor; the third sub-circuit includes a third transistor. A control electrode of the first transistor is connected with the second clock signal; a source electrode of the first transistor is connected with the signal input end; a drain electrode of the first transistor is connected with a control electrode and a source electrode of the second transistor. A drain electrode of the second transistor is connected with a control electrode of the fourth transistor. A control electrode of the third transistor is connected with the control end of the driver circuit; a source electrode of the third transistor is connected with the at least one low-voltage end; a drain electrode of the third transistor is connected with a control electrode of the fourth transistor. A source electrode of the fourth transistor is connected with the at least one low-voltage end; a drain electrode of the fourth transistor is connected with the control end of the driver circuit. A high voltage signal or the second clock signal is inputted from the signal input end.

A low-voltage end connected with the source electrode of the third transistor and a low-voltage end connected with the source electrode of the fourth transistor are a same voltage end.

The pull-down circuit further includes a fourth sub-circuit; the fourth sub-circuit includes a fifth transistor. A control electrode of the fifth transistor is connected with the control electrode of the fourth transistor; a source electrode of the fifth transistor is connected with the at least one low-voltage end; and a drain electrode of the fifth transistor is connected with the output end of the GOA unit.

A low-voltage end connected with the source electrode of the third transistor, a low-voltage end connected with the source electrode of the fourth transistor, and a low-voltage end connected with the source electrode of the fifth transistor are a same voltage end.

The GOA unit further includes a pull-up circuit. An output end of the pull-up circuit is connected with the driver circuit so as to input a pull-up signal into the driver circuit; and the pull-up signal is configured to drive the driver circuit to be switched on.

The driver circuit includes a driving transistor. A control electrode of the driving transistor is the control end of the driver circuit and connected with the output end of the pull-up circuit; a source electrode of the driving transistor is connected with the first clock signal; and a drain electrode of the driving transistor is connected with the output end of the GOA unit.

The GOA unit further includes a reset circuit. The reset circuit is connected with the driver circuit and configured to input the low-voltage signal into the control end of the driver circuit and the output end of the GOA unit; and the low-voltage signal is configured to drive the driver circuit to be switched off and pull down a signal outputted by the GOA unit.

The pull-up circuit includes a sixth transistor and a first capacitor. A control electrode and a source electrode of the sixth transistor are connected with the pull-up signal; a drain electrode of the sixth transistor is connected with the control electrode of the driving transistor. A first end of the first capacitor is connected between the drain electrode of the sixth transistor and the control electrode of the driving transistor; and a second end of the first capacitor is connected with the output end of the GOA unit.

The reset circuit includes an eighth transistor and a ninth transistor. A control electrode of the eighth transistor is connected with a signal reset end; a source electrode of the eighth transistor is connected with the at least one low-voltage end; a drain electrode of the eighth transistor is connected with the control end of the driver circuit. A control electrode of the ninth transistor is connected with the signal reset end; a source electrode of the ninth transistor is connected with the at least one low-voltage end; and a drain electrode of the ninth transistor is connected with the output end of the GOA unit.

The high voltage signal inputted from the signal input end is equal to a turn-on voltage of a gate driver circuit.

Embodiments of the present disclose provides a gate driver circuit, comprising the above-described GOA unit.

Embodiments of the present disclosure further provide a display device, comprising the above-described gate driver circuit.

In the GOA unit provided by the embodiments of the present disclosure, when the GOA unit outputs an off signal, a control end of a driver circuit is connected with at least one low-voltage end through a pull-down circuit. A low-voltage signal is inputted into the control end of the driver circuit from the at least one low-voltage end, so that the driver circuit can keep the off state when the GOA unit outputs the off signal. Hence, a scenario that the driver circuit is switched on by a signal which is coupled in due to signal crosstalk can be avoided. When the signal is coupled in, the GOA unit will maintain the state of outputting the off signal and will not incorrectly output a driving signal as in the existing technologies, so that the incorrect switching-on of one row of pixels corresponding to the GOA unit can be avoided, and hence the row of pixels cannot be charged and display incorrect images, that is, the "abnormal image" phenomenon can be overcome.

The gate driver circuit provided by the embodiments of the present disclosure adopts the GOA unit and can avoid the incorrect switching-on of various rows of pixels corresponding to various stages of GOA units respectively, so that various rows of pixels cannot be charged and display incorrect images, and hence the "abnormal image" phenomenon can be overcome.

The display device provided by the embodiments of the present disclosure adopts the gate driver circuit and can avoid the incorrect switching-on of various rows of pixels corresponding to various stages of GOA units respectively, so that various rows of pixels cannot be charged and display incorrect images, and hence the "abnormal image" phenomenon can be overcome.

### BRIEF DESCRIPTION OF THE DRAWINGS

The accompanying drawings are provided for more clear understanding of the present disclosure, are one part of the description, are intended to illustrate the present disclosure together with the following example embodiments, and are not intended to limit the present disclosure. In the accompanying drawings:
FIG. 1 is a schematic structural view of a GOA unit provided by an embodiment of the present disclosure;
FIG. 2 is a circuit diagram of a GOA unit provided by an embodiment of the present disclosure;
FIG. 3 is a timing sequence diagram of signals in the circuit diagram as shown in FIG. 2;
FIG. 4 is a circuit diagram of a GOA unit provided by an embodiment of the present disclosure;
FIG. 5 is a circuit diagram of a GOA unit provided by an embodiment of the present disclosure; and
FIG. 6 is a circuit diagram of a GOA unit provided by an embodiment of the present disclosure.

### DETAILED DESCRIPTION

Detailed description will be given below to the example embodiments of the present disclosure with reference to the accompanying drawings. It should be understood that the example embodiments described here are only intended to illustrate the present disclosure but not intended to limit the present disclosure.

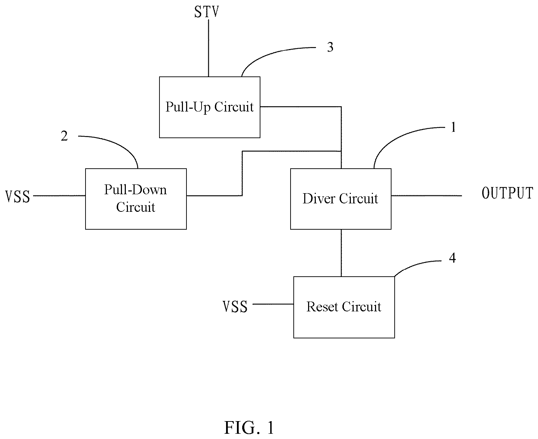

The embodiments of the present disclosure provide a GOA unit. FIG. 1 is a schematic diagram of a GOA unit provided by an embodiment of the present disclosure. As illustrated in FIG. 1, the GOA unit comprises a driver circuit 1 and a pull-down circuit 2. The driver circuit 1 is configured to output a first clock signal CLK from an output end OUTPUT of the GOA unit. The pull-down circuit 2 is connected with the driver circuit 1 and connected with a low-voltage end VSS. The pull-down circuit 2 is configured to input a low-voltage signal provided by the low-voltage end VSS into a control end of the driver circuit 1 when the GOA unit outputs an off signal, so that the driver circuit 1 can be in an off state under the control of the low-voltage signal.

In the embodiment, when the GOA unit outputs the off signal, the pull-down circuit 2 inputs the low-voltage signal provided by the low-voltage end VSS into the control end of the driver circuit 1, so that the driver circuit 1 can maintain the off state when the GOA unit outputs the off signal, and hence the driver circuit 1 cannot be switched on by any signal which is coupled in due to signal crosstalk. Moreover, when the signal is coupled in, the GOA unit will maintain the state of outputting the off signal and will not incorrectly output a driving signal as in the existing technologies, and hence can avoid the incorrect switching-on of one row of pixels corresponding to the GOA unit. Thus, the row of pixels cannot be charged and display incorrect images, and hence the "abnormal image" phenomenon can be overcome.

In addition, the GOA unit further comprises a pull-up circuit 3. An output end of the pull-up circuit 3 is connected with the driver circuit 1 and configured to input a pull-up signal into the driver circuit 1. The pull-up signal pulls up an electric potential of a pull-up node PU (namely a node between the pull-up circuit 3 and the driver circuit 1), so that the driver circuit 1 can be switched on.

In the embodiment, if the GOA unit is disposed on the first row of a gate driver circuit, the pull-up signal is an STV signal, namely a start signal for display. If the GOA unit is disposed on the second row or any subsequent row of the gate driver circuit, the pull-up signal is a signal outputted by an output end OUTPUT of a GOA unit in a previous row.

In addition, the GOA unit further comprises a reset circuit 4. The reset circuit 4 is connected with the driver circuit 1 and configured to input the low-voltage signal into the control end of the driver circuit 1 and the output end OUTPUT of the GOA unit, so that the driver circuit 1 can be switched off and the signal outputted by the GOA unit can be pulled down.

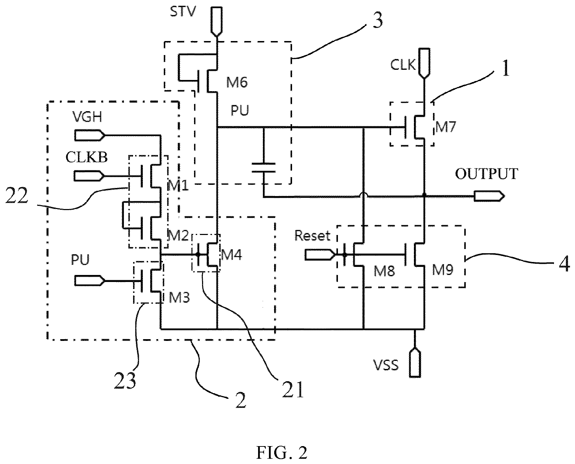

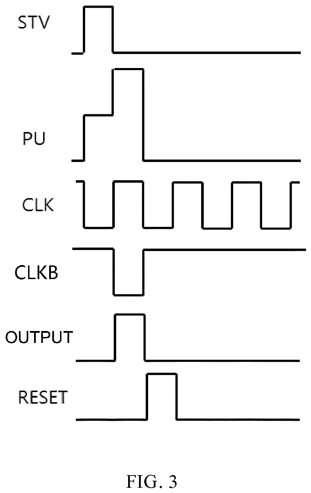

FIG. 2 is a circuit diagram of a GOA unit provided by an embodiment of the present disclosure, and FIG. 3 is a timing sequence diagram of signals in the circuit diagram as shown in FIG. 2. Description will be given below to the circuit structure of the GOA unit and the working principle of the GOA unit in the embodiment of the present disclosure with reference to FIGs. 2 and 3. It should be noted that thin-film transistors (TFTs) are N-type transistors in FIG. 2. It should be understood that the TFTs may also be P-type transistors.

As illustrated in FIG. 2, the pull-down circuit 2 may include a first sub-circuit 21, a second sub-circuit 22 and a third sub-circuit 23. A first end of the first sub-circuit 21 is connected with a control end of the driver circuit 1; a second end of the first sub-circuit 21 is connected with a low-voltage end VSS; and a third end of the first sub-circuit 21 is connected with the second sub-circuit 22 and the third sub-circuit 23. A first end of the second sub-circuit 22 is connected with a signal input end; a second end of the second sub-circuit 22 is connected with a second clock signal CLKB; and a third end of the second sub-circuit 22 is connected with the third end of the first sub-circuit 21. A first end of the third sub-circuit 23 is connected with the low-voltage end VSS; a second end of the third sub-circuit 23 is connected with the control end of the driver circuit 1; and a third end of the third sub-circuit 23 is connected with the third end of the first sub-circuit 21. In the embodiment, the signal input end may be a high-voltage end VGH, or the second clock signal CLKB may be inputted from the signal input end.

Specifically, as illustrated in FIG. 2, the first sub-circuit 21 may include a fourth transistor M4. A control electrode of the fourth transistor M4 is the third end of the first sub-circuit 21 and connected with the second sub-circuit 22 and the third sub-circuit 23; a source electrode of the fourth transistor M4 is the second end of the first sub-circuit 21 and connected with the low-voltage end VSS; and a drain electrode of the fourth transistor M4 is the first end of the first sub-circuit 21 and connected with the control end of the driver circuit 1.

The second sub-circuit 22 may include a first transistor M1 and a second transistor M2. A control electrode of the first transistor M1 is the second end of the second sub-circuit 22 and connected with the second clock signal CLKB; a source electrode of the first transistor M1 is the first end of the second sub-circuit 22 and connected with the signal input end (namely the high-voltage end VGH); and a drain electrode of the first transistor M1 is connected with a control electrode and a source electrode of the second transistor M2. A drain electrode of the second transistor M2 is the third end of the second sub-circuit 22 and connected with the third end of the first sub-circuit 21.

The third sub-circuit 23 may include a third transistor M3. A control electrode of the third transistor M3 is the second end of the third sub-circuit 23 and connected with the control end of the driver circuit 1; a source electrode of the third transistor M3 is the first end of the third sub-circuit 23 and connected with the low-voltage end VSS; and a drain electrode of the third transistor M3 is the third end of the third sub-circuit 23 and connected with the third end of the first sub-circuit 21.

The driver circuit 1 may include a driving transistor M7. A control electrode of the driving transistor M7 is the control end of the driver circuit 1 and connected with an output end of the pull-up circuit 3; a source electrode of the driving transistor M7 is connected with the first clock signal CLK; and a drain electrode of the driving transistor M7 is connected with the output end OUTPUT of the GOA unit.

The pull-up circuit 3 may include a sixth transistor M6 and a first capacitor C1. A control electrode and a source electrode of the sixth transistor M6 are connected with a pull-up signal, and a drain electrode of the sixth transistor M6 is connected with the control electrode of the driving transistor M7. A first end of the first capacitor C1 is connected between the drain electrode of the sixth transistor M6 and the control electrode of the driving transistor M7, and a second end of the first capacitor C1 is connected with the output end OUTPUT of the GOA unit.

The reset circuit 4 may include an eighth transistor M8 and a ninth transistor M9. A control electrode of the eighth transistor M8 is connected with a signal reset end Reset; a source electrode of the eighth transistor M8 is connected with the low-voltage end VSS; and a drain electrode of the eighth transistor M8 is connected with the control electrode of the driving transistor M7. A control electrode of the ninth transistor M9 is connected with the signal reset end Reset; a source electrode of the ninth transistor M9 is connected with the low-voltage end VSS; and a drain electrode of the ninth transistor M9 is connected with the output end OUTPUT of the GOA unit.

An operating process of elements in the GOA unit provided by the embodiments of the present disclosure may include a first period, a second period, a third period and a fourth period.

In the first period, the second clock signal CLKB is in a high level, so that the first transistor M1 and the second transistor M2 can be switched on. The reset signal Reset is in a low level, so that the eighth transistor M8 and the ninth transistor M9 can be switched off. The pull-up signal (which is an STV signal here and indicates that the GOA unit is disposed on the first row of the gate driver circuit) is in a high level and configured to pull up the electric potential of the pull-up node PU. In this case, the first end of the first capacitor C1 is charged, so that the driving transistor M7 is switched on, and hence the first clock signal CLK is outputted from the output end OUTPUT through the driving transistor M7 and inputted into the second end of the first capacitor. And meanwhile, the third transistor M3 is switched on, so that the control electrode of the fourth transistor M4 is connected with the low-voltage end VSS, and hence the fourth transistor M4 is switched off in the first period.

In the second period, the STV signal is changed to a low level, so that the sixth transistor M6 is switched off, and hence the pull-up node PU maintains a high level and is in the flooding state, the first clock signal CLK is changed from the low level to the high level, so that the output end OUTPUT of the GOA unit outputs a high level signal. Meanwhile, the second end of the first capacitor C1 is charged so that the first capacitor C1 is subjected to bootstrapping, and hence the electric potential of the pull-up node PU can be further increased.

In the third period, the reset signal Reset is changed to from a low level to a high level, so that the eighth transistor M8 and the ninth transistor M9 can be switched on, and hence the pull-up node PU is connected with the low-voltage end VSS and the output end OUTPUT of the GOA unit is also connected with the low-voltage end VSS. In this case, the driving transistor M7 is switched off and the GOA unit outputs the off signal.

In the fourth period, the second clock signal CLKB is in high level, so that the first transistor M1 and the second transistor M2 can be switched on, and hence the electric potential of the control electrode of the fourth transistor M4 is in high level and the fourth transistor M4 is switched on. In this case, the low-voltage end VSS is connected with the control electrode of the driving transistor M7 through the fourth transistor M4, so that the driving transistor M7 can keep the off state in this period and cannot be incorrectly switched on by a signal which is coupled into the GOA unit. Hence, the GOA does not output incorrect driving signals. Thus, one row of pixels corresponding to the GOA unit cannot be incorrectly switched on and display incorrect images.

Description is given above to the structure of the GOA unit and the working principle of the GOA unit in each cycle period of the GOA unit with reference to the accompanying drawings. As seen from the description, when the GOA unit outputs the off signal, a scenario that the GOA unit is incorrectly switched on and incorrectly outputs a driving signal can be avoided, and hence display errors on the display device can be prevented.

In the embodiments of the present disclosure, the circuit structure of the GOA unit is not limited to the structure as shown in FIG. 2.

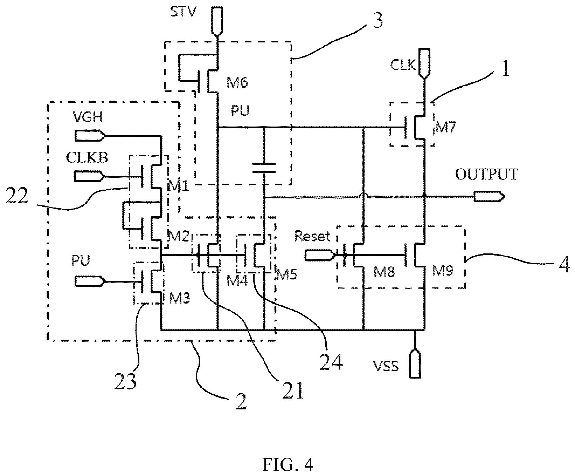

FIG. 4 is a circuit diagram of the GOA unit provided by an embodiment of the present disclosure. Specifically, as illustrated in FIG. 4, the pull-down unit 2 further includes a fourth sub-circuit 24. A first end of the fourth sub-circuit 24 is connected with the output end OUTPUT of the GOA unit; a second end of the fourth sub-circuit 24 is connected with the low-voltage end VSS; and a third end of the fourth sub-circuit 24 is connected with the third end of the second sub-circuit 22 and the third end of the third sub-circuit 23. More specifically, the fourth sub-circuit 24 may include a fifth transistor M5. A control electrode of the fifth transistor M5 is the third end of the fourth sub-circuit 24 and connected with the drain electrode of the second transistor M2 in the second sub-circuit 22 and the drain electrode of the third transistor M3 in the third sub-circuit 23; a source electrode of the fifth transistor M5 is the second end of the fourth sub-circuit 24 and connected with the low-voltage end VSS; and a drain electrode of the fifth transistor M5 is the first end of the fourth sub-circuit 24 and connected with the output end OUTPUT of the GOA unit. In the embodiment, when the GOA unit outputs the off signal, both the second end of the first capacitor C1 and the output end OUTPUT are connected with the low-voltage end VSS, so that the signal outputted from the output end OUTPUT of the GOA unit is further guaranteed to be an off signal, and hence the adverse effect of the signal which is coupled into the GOA unit can be maximally reduced on the GOA unit.

In the embodiment as shown in FIG. 4, the low-voltage ends connected with the third transistor M3, the fourth transistor M4 and the fifth transistor M5 are the same low-voltage end so as to reduce the number of power ports needed to be arranged. In addition, the low-voltage end connected with the pull-down circuit 2 and the low-voltage end connected with the reset circuit 4 have the same voltage so as to reduce the number of the power ports needed to be arranged.

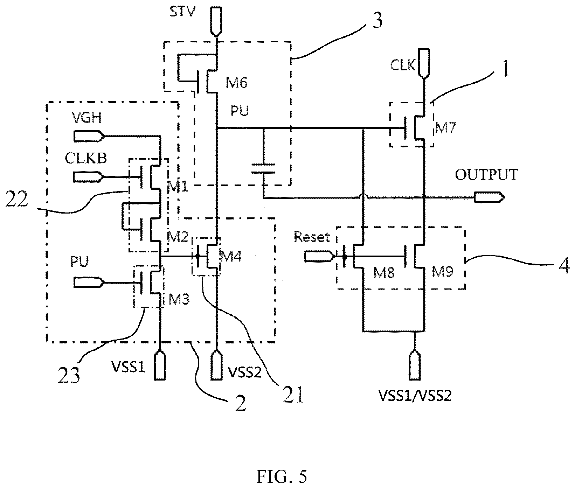

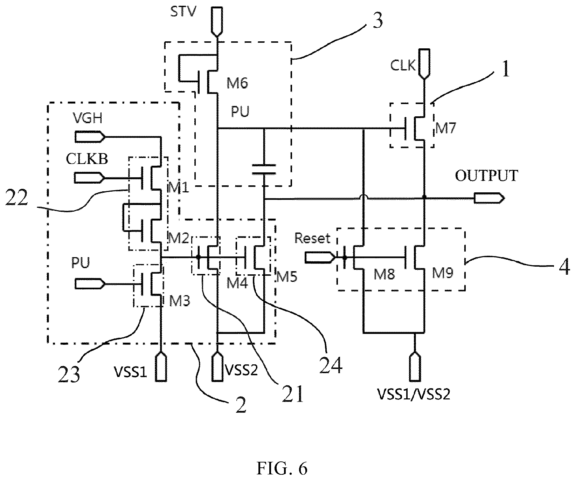

In other embodiments of the present disclosure, the pull-down circuit 2 may also be connected with a plurality of low-voltage ends. For instance, as illustrated in FIG. 5, the source electrode of the third transistor M3 is connected with a first low-voltage end VSS1, and the source electrode of the fourth transistor M4 is connected with a second low-voltage end VSS2. In addition, as illustrated in FIG. 6, the source electrode of the third transistor M3 is connected with the first low-voltage end VSS1, and both the source electrode of the fourth transistor M4 and the source electrode of the fifth transistor M5 are connected with the second low-voltage end VSS2. It should be understood that: as for the embodiment as shown in FIG. 6, the low-voltage end connected with the source electrode of the fourth transistor M4 and the low-voltage end connected with the source electrode of the fifth transistor M5 may also be different low-voltage ends. When the GOA unit outputs the off signal, a low-voltage signal is inputted into the control electrode of the driving transistor M7 from the low-voltage end connected with the source electrode of the fourth transistor M4.

In addition, the low-voltage end connected with the pull-down circuit 2 and the low-voltage end connected with the reset circuit 4 may be different low-voltage ends, as long as the low-voltage signals outputted by the low-voltage ends that are connected with the pull-down circuit 2 or the reset circuit 4 can drive the driving transistor M7 to be switched off.

In the embodiments of the present disclosure, a voltage inputted from the signal input end may be equal to a turn-on voltage of the gate driver circuit. For instance, a voltage outputted from the high-voltage end VGH may be equal to the turn-on voltage of the gate driver circuit. In this case, by direct utilization of the existing high voltage in the gate driver circuit, the number of the power ports can be reduced, and hence the circuit structure can be simplified.

In addition, it should be noted that: in the embodiments of the present disclosure, a signal waveform of the second clock signal CLKB is not limited to the waveform as shown in FIG. 3, as long as the voltage of the control electrode of the fourth transistor M4 is in low level when the pull-up node PU is in high level (as for an embodiment in which the pull-down circuit 2 includes the fifth transistor M5, the voltage of the control electrode of the fifth transistor M5 may also need to be pulled down to low level).

In the GOA unit provided by the embodiments of the present disclosure, when the GOA unit outputs the off signal, the pull-down circuit 2 allows the control end of the driver circuit 1 to be connected with the low-voltage end VSS, and the low-voltage signal is inputted into the control end of the driver circuit 1 from the low-voltage end VSS. Thus, the driver circuit 1 can keep the off state when the GOA unit outputs the off signal, and hence a scenario that the driver circuit 1 is switched on by a signal which is coupled into the GOA unit due to signal crosstalk can be avoided. Moreover, even if the signal is coupled into the GOA unit, the GOA unit may also maintain the state of outputting the off signal and may not incorrectly output the driving signal as in the existing technologies, so that the incorrect switching-on of one row of pixels corresponding to the GOA unit can be avoided. Thus, the row of pixels cannot be charged and display incorrect images, and hence the "abnormal image" phenomenon can be overcome.

The embodiments of the present disclosure further provide a gate driver circuit, which comprises the GOA unit provided by the above-described embodiments.

The gate driver circuit provided by the embodiments adopt the GOA unit provided by the above-described embodiments and can avoid the incorrect switching-on of various rows of pixels corresponding to various stages of GOA units respectively, so that various rows of pixels cannot be charged and display incorrect images, and hence the "abnormal image" phenomenon can be overcome.

The embodiments of the present disclosure further provide a display device, which comprises the gate driver circuit provided by the above-described embodiments.

The display device provided by the embodiments adopts the gate driver circuit in the above embodiments and can avoid the incorrect switching-on of various rows of pixels corresponding to various stages of GOA units respectively, so that various rows of pixels cannot be charged and display incorrect images, and hence the "abnormal image" phenomenon can be overcome.

It should be understood that the above embodiments are only example embodiments adopted for illustrating the principle of the present disclosure and not intended to limit the present disclosure. Various modifications and improvements may be made by those skilled in the art without departing from the spirit and the essence of the present disclosure and shall also fall within the scope of protection of the present disclosure.

## Claims

1. A gate on array (GOA) unit, comprising:
a driver circuit configured to output a first clock signal from an output end of the GOA unit; and
a pull-down circuit connected with the driver circuit, the pull-down circuit also connected with at least one low-voltage end that provides a low-voltage signal, the pull-down circuit configured to input the low-voltage signal into a control end of the driver circuit to drive the driver circuit to be in an off state when the GOA unit outputs an off signal.

2. The GOA unit according to claim 1, wherein the pull-down circuit includes a first sub-circuit, a second sub-circuit and a third sub-circuit;
a first end of the first sub-circuit is connected with the control end of the driver circuit; a second end of the first sub-circuit is connected with the at least one low-voltage end; a third end of the first sub-circuit is connected with the second sub-circuit and the third sub-circuit;
a first end of the second sub-circuit is connected with a signal input end; a second end of the second sub-circuit is connected with a second clock signal; a third end of the second sub-circuit is connected with the third end of the first sub-circuit;
a first end of the third sub-circuit is connected with the at least one low-voltage end; a second end of the third sub-circuit is connected with the control end of the driver circuit; and a third end of the third sub-circuit is connected with the third end of the first sub-circuit.

3. The GOA unit according to claim 2, wherein the pull-down circuit further includes a fourth sub-circuit;
a first end of the fourth sub-circuit is connected with the output end of the GOA unit; a second end of the fourth sub-circuit is connected with the at least one low-voltage end; and a third end of the fourth sub-circuit is connected with the third end of the second sub-circuit and the third end of the third sub-circuit.

4. The GOA unit according to claim 2 or 3, wherein the second sub-circuit includes a first transistor and a second transistor;
a control electrode of the first transistor is the second end of the second sub-circuit and connected with the second clock signal; a source electrode of the first transistor is the first end of the second sub-circuit and connected with the signal input end; a drain electrode of the first transistor is connected with a control electrode and a source electrode of the second transistor;
a drain electrode of the second transistor is the third end of the second sub-circuit and connected with the third end of the first sub-circuit; and
a high voltage signal or the second clock signal is inputted from the signal input end.

5. The GOA unit according to claim 2 or 3, wherein the third sub-circuit includes a third transistor;
a control electrode of the third transistor is the second end of the third sub-circuit and connected with the control end of the driver circuit; a source electrode of the third transistor is the first end of the third sub-circuit and connected with the at least one low-voltage end; and a drain electrode of the third transistor is the third end of the third sub-circuit and connected with the third end of the first sub-circuit.

6. The GOA unit according to claim 2 or 3, wherein the first sub-circuit includes a fourth transistor;
a control electrode of the fourth transistor is the third end of the first sub-circuit and connected with the second sub-circuit and the third sub-circuit; a source electrode of the fourth transistor is the second end of the first sub-circuit and connected with the at least one low-voltage end; and a drain electrode of the fourth transistor is the first end of the first sub-circuit and connected with the control end of the driver circuit.

7. The GOA unit according to claim 3, wherein the fourth sub-circuit includes a fifth transistor;
a control electrode of the fifth transistor is the third end of the fourth sub-circuit and connected with the third end of the second sub-circuit and the third end of the third sub-circuit; a source electrode of the fifth transistor is the second end of the fourth sub-circuit and connected with the at least one low-voltage end; and a drain electrode of the fifth transistor is the first end of the fourth sub-circuit and connected with the output end of the GOA unit.

8. The GOA unit according to claim 2, wherein the first sub-circuit includes a fourth transistor; the second sub-circuit includes a first transistor and a second transistor; the third sub-circuit includes a third transistor;
a control electrode of the first transistor is connected with the second clock signal; a source electrode of the first transistor is connected with the signal input end; a drain electrode of the first transistor is connected with a control electrode and a source electrode of the second transistor;
a drain electrode of the second transistor is connected with a control electrode of the fourth transistor;
a control electrode of the third transistor is connected with the control end of the driver circuit; a source electrode of the third transistor is connected with the at least one low-voltage end; a drain electrode of the third transistor is connected with a control electrode of the fourth transistor;
a source electrode of the fourth transistor is connected with the at least one low-voltage end; a drain electrode of the fourth transistor is connected with the control end of the driver circuit; and
a high voltage signal or the second clock signal is inputted from the signal input end.

9. The GOA unit according to claim 8, wherein a low-voltage end connected with the source electrode of the third transistor and a low-voltage end connected with the source electrode of the fourth transistor are a same voltage end.

10. The GOA unit according to claim 8, wherein the pull-down circuit further includes a fourth sub-circuit; the fourth sub-circuit includes a fifth transistor;
a control electrode of the fifth transistor is connected with the control electrode of the fourth transistor; a source electrode of the fifth transistor is connected with the at least one low-voltage end; and a drain electrode of the fifth transistor is connected with the output end of the GOA unit.

11. The GOA unit according to claim 10, wherein a low-voltage end connected with the source electrode of the third transistor, a low-voltage end connected with the source electrode of the fourth transistor, and a low-voltage end connected with the source electrode of the fifth transistor are a same voltage end.

12. The GOA unit according to claim 1, further comprising a pull-up circuit, wherein an output end of the pull-up circuit is connected with the driver circuit so as to input a pull-up signal into the driver circuit; and the pull-up signal is configured to drive the driver circuit to be switched on.

13. The GOA unit according to claim 12, wherein the driver circuit includes a driving transistor;
a control electrode of the driving transistor is the control end of the driver circuit and connected with the output end of the pull-up circuit; a source electrode of the driving transistor is connected with the first clock signal; and a drain electrode of the driving transistor is connected with the output end of the GOA unit.

14. The GOA unit according to claim 12 or 13, further comprising a reset circuit, wherein the reset circuit is connected with the driver circuit and configured to input the low-voltage signal into the control end of the driver circuit and the output end of the GOA unit; and the low-voltage signal is configured to drive the driver circuit to be switched off and pull down a signal outputted by the GOA unit.

15. The GOA unit according to claim 13, wherein the pull-up circuit includes a sixth transistor and a first capacitor;
a control electrode and a source electrode of the sixth transistor are connected with the pull-up signal; a drain electrode of the sixth transistor is connected with the control electrode of the driving transistor;
a first end of the first capacitor is connected between the drain electrode of the sixth transistor and the control electrode of the driving transistor; and a second end of the first capacitor is connected with the output end of the GOA unit.

16. The GOA unit according to claim 14, wherein the reset circuit includes an eighth transistor and a ninth transistor;
a control electrode of the eighth transistor is connected with a signal reset end; a source electrode of the eighth transistor is connected with the at least one low-voltage end; a drain electrode of the eighth transistor is connected with the control end of the driver circuit;
a control electrode of the ninth transistor is connected with the signal reset end; a source electrode of the ninth transistor is connected with the at least one low-voltage end; and a drain electrode of the ninth transistor is connected with the output end of the GOA unit.

17. The GOA unit according to claim 4 or 8, wherein the high voltage signal inputted from the signal input end is equal to a turn-on voltage of a gate driver circuit.

18. A gate driver circuit, comprising the GOA unit according to any one of claims 1 to 17.

19. A display device, comprising the gate driver circuit according to claim 18.
